# EUROPÄISCHE PATENTSCHRIFT

(11) **EP 3 827 520 B1**
(45) Veröffentlichungstag und Bekanntmachung des Hinweises auf die Patenterteilung: **23.11.2022**
(21) Anmeldenummer: 19746049.6
(22) Anmeldetag: 19.07.2019
(51) Int. Cl.: H03K 17/955

(54) **FEUCHTEUNABHÄNGIGER KAPAZITIVER SENSOR FÜR BELIEBIGE SCHALTVORGÄNGE**
MOISTURE-INDEPENDENT CAPACITIVE SENSOR FOR ARBITRARY SWITCHING PROCESSES
CAPTEUR CAPACITIF INDÉPENDANT DE L'HUMIDITÉ, POUR OPÉRATIONS DE COMMUTATION QUELCONQUES

(30) Priorität: 24.07.2018 DE 102018117901
(43) Veröffentlichungstag der Anmeldung: 02.06.2021
(73) Patentinhaber: Reime, Gerd, 77815 Bühl (DE)
(72) Erfinder: Reime, Gerd, 77815 Bühl (DE)
(74) Vertreter: RPK Patentanwälte Reinhardt, Pohlmann und Kaufmann Partnerschaft mbB
(86) Internationale Anmeldenummer: PCT/EP2019/069547
(87) Internationale Veröffentlichungsnummer: WO 2020/020786

(56) Entgegenhaltungen:
- US-A1- 2011 148 648
- US-A1- 2012 112 767
- US-A1- 2018 135 339
- MEHEDI MASUD ET AL: "Contactless Interrogation System for Capacitive Sensors with Time-Gated Technique", PROCEEDINGS, Bd. 1, Nr. 4, 1. Januar 2017 (2017-01-01), Seite 395, XP055625199, DOI: 10.3390/proceedings1040395

## Beschreibung

Die Erfindung betrifft einen kapazitiven Annäherungssensor mit einer Sensoranordnung nach dem Oberbegriff des Anspruches 1 sowie ein Verfahren zur Bestimmung der Annäherung eines Objekts an eine Sensoranordnung eines kapazitiven Annäherungssensors nach dem Oberbegriff des Anspruches 7.

Aus der dem Oberbegriff der unabhängigen Ansprüche zu Grunde liegenden US 2018/135339 A1 ist ein kapazitiver Annäherungssensor mit einem Schwingkreis bekannt. In einem Zustand, in dem ein hochfrequentes Signal mit einer ersten Erfassungsfrequenz in einen LCR-Resonanzkreis eingegeben wird, wird bei Erkennen, dass ein Spannungssignal größer gleich einem oberen Grenzschwellwert oder kleiner gleich einem ersten unteren Grenzschwellwert ist, ein hochfrequentes Signal mit einer zweiten Detektionsfrequenz in den Resonanzkreis gegeben. Damit erkennt das hochfrequente Signal mit der zweiten Detektionsfrequenz die Nähe eines menschlichen Körpers oder von Wasser zu einer Sensorelektrode, indem festgestellt wird, dass das Spannungssignal kleiner gleich einem zweiten unteren Grenzwertschwellwert ist. Dazu ist wenigstens eine Sensorelektrode als Resonanzkondensator im Schwingkreis eingebunden. Der Schwingkreis ist in einem Ausgangszustand von der Erregerschaltung mit einer Frequenz unterhalb einer Resonanzfrequenz des Schwingkreises angeregt. Ein Medium mit resistivem Anteil wie eine Feuchtigkeit ist zwischen Sensorelektrode und einem Grundpotential anordenbar, was zu einer Verstimmung des Schwingkreises führt. Hingegen führt eine Annäherung einer weiteren Kapazität eines Objekts an die Sensorelektrode zu einer Verstimmung des Schwingkreises mit einem am Schwingkreis abgreifbaren Ausgangssignal mit einer gegenüber dem Ausgangszustand geänderten Amplitude selbst bei Anwesenheit des Mediums mit resistivem Anteil. Das Ausgangssignal wird zur Bestimmung der Annäherung der weiteren Kapazität ausgewertet und die Annäherung der weiteren Kapazität an der Änderung der Amplitude des Ausgangssignals erkannt.

US 2011/0148648 A1 ist ein Insassenerkennungssystem und -verfahren zur Erfassung eines Insassen bekannt, der auf einem Fahrzeugsitz sitzt. Dazu ist eine Elektrode in einem Fahrzeugsitz in der Nähe einer erwarteten Position des Insassen angeordnet, die in eine Sitzheizung integriert werden kann. Eine Steuerschaltung steuert die Sitzheizung. Ein Signalgenerator ist mit der Elektrode gekoppelt und konfiguriert, um der Elektrode eine Vielzahl von Signalen bei einer Vielzahl von Frequenzen auszugeben. Die Insassenerkennungsschaltung erkennt Spannungen, die auf die Vielzahl von Signalen bei der Vielzahl von Frequenzen reagieren, und erfasst einen Belegungszustand basierend auf den erfassten Spannungen. Eine mit der Elektrode und der Steuerschaltung gekoppelte LC-Schaltung unterdrückt die von der Steuerschaltung erzeugte Kapazität. Dabei wird zwischen einem nassen und einem trockenen Sitz unterschieden.

Kapazitive Annäherungssensoren, deren Wirkungsprinzip auf der Verstimmung eines Resonanzkreises beruht, sind allgemein bekannt. Dabei wird vorzugsweise über einen Koppelkondensator mit kleinem Kapazitätswert oder über einen relativ hochohmigen Koppelwiderstand eine feste Frequenz auf einen Schwingkreis gegeben, der in der Regel auf die vorgegebene Frequenz abgestimmt ist. Hochohmig eingekoppelt bedeutet in diesem Zusammenhang und im Rahmen dieser Erfindung, dass eine kleine Verstimmung des Schwingkreises schon eine merkliche Amplitudenänderung an diesem hervorruft.

Wird eine Sensorelektrode an diesen Schwingkreis angeschlossen, so wird eine Änderung des elektrischen Feldes in der Umgebung der Sensorelektrode des Schwingkreises - z.B. durch Handannäherung - zu einer Verstimmung des Schwingkreises und somit zu einer Beeinflussung der Schwingungsamplitude führen, da die Kapazität zwischen der Sensorelektrode und dem elektrischen Erdpotential gemessen wird. Die Veränderung der Schwingungsamplitude kann ausgewertet werden und einen Steuervorgang auslösen.

Neben diesem Wirkprinzip gibt es auch noch weitere, z.B. die Aufladung der Kapazität einer Messelektrode mittels definierten Stroms und die Auswertung der entstehenden Spannung in einem vorgegebenen Zeitraum bzw. die Auswertung der Zeit, bis ein vorgegebener Spannungspegel erreicht wird.

Alle diese Wirkprinzipien haben allerdings den Nachteil, dass Feuchtigkeit zwischen Sensorelektrode und elektrischem Erdpotential die gewünschte Funktion beeinflusst bzw. sogar ganz unterbindet, da Feuchtigkeit, insbesondere Wasserflächen oder nasse Tücher direkt zwischen Sensorelektrode und elektrischem Erdpotential aufgrund ihrer Leitfähigkeit wie eine große Kapazität wirken. Liegt zum Beispiel ein nasses Tuch komplett auf der Sensorfläche und zusätzlich auf einer umgebenden Fläche mit elektrischem Erdpotential, so kann in der Regel eine Handannäherung definitiv nicht mehr erfasst werden.

Ziel der hier vorgestellten Erfindung ist die Schaffung eines kapazitiven Annäherungssensors, der oben genannte Nachteile nicht aufweist.

Dies wird durch einen kapazitiven Annäherungssensor mit einer Sensoranordnung mit den Merkmalen des Anspruches 1 sowie durch ein Verfahren zur Bestimmung der Annäherung eines Objekts an eine Sensoranordnung eines kapazitiven Annäherungssensors mit den Merkmalen des Patentanspruchs 7 gelöst. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch erläuternde Sachverhalte aus der Beschreibung und durch Details aus den Figuren ergänzt werden, wobei weitere Ausführungsvarianten der Erfindung aufgezeigt werden

Der kapazitive Annäherungssensor weist eine Sensoranordnung mit einem Schwingkreis auf, in dem wenigstens eine Induktivität und wenigstens eine Kapazität vorgesehen sind. Die Kapazität ist im Wesentlichen gegenüber einem Grundpotential gebildet, das vorzugsweise ein neutrales Erdpotential ist. Anstelle des Begriffs "Grundpotential" kann auch der Begriff "Bezugspotential" verwendet werden. Im Schwingkreis ist wenigstens eine Sensorelektrode angeordnet. Über eine Erregerschaltung wird der Schwingkreis erregt. Findet eine Änderung im Umfeld des kapazitiven Annäherungssensors zum Beispiel durch Annäherung eines Objekts statt, führt dies zu einer Verstimmung des Schwingkreises, was sich in einem am Schwingkreis abgreifbaren Ausgangssignal äußert. Mittels einer Auswerteschaltung wird dieses Ausgangssignal zur Bestimmung der Annäherung eines Objekts ausgewertet.

Die Sensorelektrode ist als Resonanzkondensator in den Schwingkreis eingebunden. Der Schwingkreis wird in einem Ausgangszustand von der Erregerschaltung mit einer Frequenz unterhalb einer Resonanzfrequenz des Schwingkreises angeregt. Befindet sich ein Medium mit resistivem Anteil wie zum Beispiel ein feuchtes Tuch zwischen der Sensorelektrode und dem Grundpotential, führt dies bei dieser Anordnung zu einer Verstimmung des Schwingkreises mit einem Ausgangssignal, das gegenüber dem Ausgangszustand eine gleichbleibende oder nahezu gleichbleibende Amplitude aufweist. Wird hingegen eine weitere Kapazität eines Objekts wie zum Beispiel eine Hand oder ein Finger der Sensorelektrode angenähert, führt dies dann aber zu einer Verstimmung des Schwingkreises mit einem Ausgangssignal mit einer gegenüber dem Ausgangszustand geänderten Amplitude und dies auch dann, wenn das Medium mit resistivem Anteil, also zum Beispiel das feuchte Tuch, gleichzeitig anwesend ist.

Die Erregerschaltung ist so betreibbar, dass der Schwingkreis mit N Erregerschwingungen periodisch angeregt wird. Dies bedeutet, dass keine dauerhafte periodische Erregerschwingung vorliegt, sondern der Schwingkreis angestoßen wird und aufgrund der zahlenmäßig begrenzten Erregerschwingungen wieder ausschwingen kann. Die Zahl N ist kleiner 10. Die Auswerteschaltung wertet dann die Amplitude des Ausgangssignals während der N Erregerschwingungen und/oder kurz nach den Erregerschwingungen, vorzugsweise etwa ab der siebten Schwingung aus. In der Praxis hat sich gezeigt, dass durch die begrenzte Anzahl an Erregerschwingungen und das Einschwing- und Ausschwingverhalte des Schwingkreises vorzugsweise die Rahmenbedingungen geschaffen werden können, um kapazitive Änderungen mit resistivem Anteil von vorzugsweise rein kapazitiven Änderungen deutlich unterschieden zu können.

Damit kann die Auswerteschaltung die Annäherung der weiteren Kapazität an der Änderung der Amplitude des Ausgangssignals eindeutig erkennen. So lässt sich selbst bei einem geerdeten feuchten Tuch noch eindeutig eine Handannäherung erkennen, also zum Beispiel auch um einen Griff zum Öffnen oder Schließen einer Öffnung zu betätigen. Das dafür erforderliche Grundprinzip wird im Rahmen der Beschreibungen noch näher erläutert.

Auch wenn sich ein nasses Tuch über der Sensorfläche und der Fläche mit dem elektrischem Erdpotential befindet oder die Sensorfläche mit einem geschlossenem Wasserfilm bedeckt ist, der auch eine Fläche mit elektrischem Erdpotential direkt berührt, erfasst der kapazitive Annäherungssensor eine Handannäherung eindeutig. Anwendungsmöglichkeiten für den hier beschriebenen Sensor ergeben sich z.B. im Bereich der "weißen Ware", bei Fahrzeugtürgriffen, insbesondere wenn in Zukunft "grifffreie" Fahrzeuge gefertigt werden, bei denen nur ein Sensor in der Außenfläche eines Fahrzeugs den Öffnungs- oder Schließvorgang einleiten soll, sowie allgemein im Industriebereich.

Die Erregerschaltung, die vorzugsweise als Frequenzgenerator ausgebildet ist, regt den Schwingkreis zumindest zeitweise periodisch an. Eine derart periodische Anregung lässt sich im Amplitudenverlauf des im Schwingkreis abgreifbaren Ausgangssignals erkennen, sodass eine deutliche Signalerkennung gewährleistet ist.

Günstigerweise liegt die Zahl N zwischen zwei und sechs. Die Auswerteschaltung wertet dann die Amplitude des Ausgangssignals vorzugsweise etwa ab der siebten Schwingung aus. In der Praxis hat sich gezeigt, dass durch diese begrenzte Anzahl an Erregerschwingungen kapazitive Änderungen mit resistivem Anteil von vorzugsweise rein kapazitiven Änderungen deutlich unterschieden werden können.

Damit kann das System dynamisch die Annäherung oder die Anwesenheit z.B. einer Hand oder eines anderen Körperteils erfassen, Obwohl z.B. eine feuchte Verschmutzung - wie ein feuchtes Tuch, Eis oder Schnee - mit Bezug zu einem Grund- oder Massepotential vorliegt.

Vorzugsweise umfasst die Erregerschaltung einen periodisch einmalig angestoßenen Schwingkreis, wobei die Erregerschwingungen aus dem Ausklingen eines Erreger-Schwingkreises entnommen sind. Dies erlaubt das Einbringen einer Erregerschwingung auf eine einfache und günstige Art mit wenigen Bauelementen.

Grundsätzlich kann das Grundpotential ein beliebiges Bezugspotential sein, gegenüber dem die Signalabweichung des Ausgangssignals gemessen wird. Vorzugsweise ist das Grundpotential ein elektrisches Erdpotential, um dadurch einen eindeutigen Bezug zu gewährleisten.

Wenn es darum geht, die Betriebssicherheit durch Erkennung von Menschen zu erhöhen, kann das Objekt mit der weiteren Kapazität vorzugsweise eine Hand oder ein anderes Körperteil eines Menschen sein.

Andererseits hat das Medium, das zwischen der Sensorelektrode und z.B. dem Erdpotential als Grundpotential angeordnet ist, vorzugsweise einen resistivem Anteil wie z.B. ein geerdetes, feuchtes Objekt wie ein Tuch, da selbst dann mit dem Annäherungssensor eindeutig zwischen dem geerdeten Objekt und einer Handannäherung unterschieden werden kann.

Günstigerweise ist eine weitere Elektrode parallel zu der wenigstens einen Sensorelektrode angeordnet und dazu bestimmt und geeignet, EMV-Störungen aufzunehmen, die auch die Sensorelektrode beeinflussen. Durch die Verwendung eines Differenzbildners zur Bildung einer Differenz zwischen dem Signal aus der Sensorelektrode und dem Signal aus der weiteren Elektrode können auf einfache Weise durch Differenzbildung EMV-Störungen eliminiert werden. Dies gilt grundsätzlich auch dann, wenn mehrere Sensorelektroden parallel zueinander angeordnet sind, um zum Beispiel verschiedene Betätigungsvorgänge zum Beispiel beim Öffnen und/oder Schließen einer Schließvorrichtung zu erkennen.

Zur Steigerung der Sensitivität ist vorzugsweise eine Induktivität vorgesehen, in die das von der Erregerschaltung erzeugte Erregungssignal einseitig eingekoppelt wird. Am anderen Ende der Induktivität ist ein Resonanzkondensator vorgesehen, der eine Sensorelektrode mit einer kleinen nach Erdpotential ausgebildeten Kapazität zur Erreichung einer Grundresonanz aufweist. Die Annäherung einer weiteren Kapazität führt dann zu einer von der Auswerteschaltung auswertbaren Verschiebung der Grundresonanz.

Verfahrensgemäß sind zur Bestimmung der Annäherung eines Objekts an eine Sensoranordnung eines kapazitiven Annäherungssensors ein Schwingkreis mit wenigstens einer Induktivität und wenigstens einer Kapazität vorgesehen. Dabei ist die Kapazität im Wesentlichen gegenüber einem Grundpotential gebildet, das vorzugsweise ein Erdpotential ist. Im Schwingkreis ist ferner wenigstens eine Sensorelektrode angeordnet. Der Schwingkreis wird von einer Erregerschaltung erregt, wobei ein am Schwingkreis abgreifbares Ausgangssignal von einer Auswerteschaltung zur Bestimmung der Annäherung eines Objekts ausgewertet wird.

Die Sensorelektrode ist als Resonanzkondensator in den Schwingkreis eingebunden. Der Schwingkreis wird in einem Ausgangszustand von der Erregerschaltung mit einer Frequenz unterhalb einer Resonanzfrequenz des Schwingkreises angeregt. Befindet sich ein Medium mit einem resistivem Anteil zwischen der Sensorelektrode und den Grundpotential, führt dies zu einer Verstimmung des Schwingkreises mit einem Ausgangssignal mit einer gegenüber dem Ausgangszustand gleichbleibenden oder nahezu gleichbleibenden Amplitude, jedoch veränderter Phase. Eine Annäherung einer weiteren Kapazität an die Sensorelektrode führt hingegen zu einer Verstimmung des Schwingkreises mit einem Ausgangssignal mit einer gegenüber dem Ausgangszustand geänderten Amplitude und dies selbst bei Anwesenheit des Mediums mit resistivem Anteil. Dazu wird der Schwingkreis mit N Erregerschwingungen periodisch angeregt. Die Zahl N ist kleiner 10. Die Auswerteschaltung wertet dann am Schwingkreis die Amplitude des Ausgangssignals während der und/oder kurz nach den N Erregerschwingungen aus. Dadurch wird der Signalunterschied zum Ausgangszustand deutlicher, da der Unterschied beim eingeschwungenen Schwingkreis geringer ausfällt als bei einem zum Schwingen angeregten Schwingkreis. Als besonders bevorzugt hat sich für die Auswertung ein Zeitbereich herausgestellt, in dem sich kein Feuchtigkeitseinfluss in der Amplitudenbeeinflussung mehr zeigt, z.B. etwa ab der siebten Schwingung, d.h. es ergibt sich vorzugsweise mit und ohne Feuchtigkeit eine gleichbleibende Amplitude. Die Auswerteschaltung erkennt die Annäherung der weiteren Kapazität an der Änderung der Amplitude des Ausgangssignals. Dadurch wird verfahrensgemäß eine eindeutige Erkennung der weiteren Kapazität gewährleistet, da sich ein signifikanter Signalunterschied in der Amplitude des Ausgangssignals unabhängig von einer möglichen Phasenverschiebung ergibt.

Günstigerweise regt die vorzugsweise als Frequenzgenerator ausgebildete Erregerschaltung den Schwingkreis wenigstens zeitweise periodisch an. Dadurch ist ein eindeutiges Erregungssignal vorhanden, das den Schwingkreis so anregt, dass auch ein deutliches Ausgangssignal zu erkennen ist.

Vorzugsweise wird der Schwingkreis mit N Erregerschwingungen periodisch angeregt, wobei die Zahl N zwischen zwei und sechs liegt. Dadurch wird der Signalunterschied zum Ausgangszustand deutlicher, besonders bevorzugt für die Auswertung ein Zeitbereich verwendet wird, in dem sich kein Feuchtigkeitseinfluss in der Amplitudenbeeinflussung mehr zeigt, z.B. etwa ab der siebten Schwingung, d.h. es ergibt sich vorzugsweise mit und ohne Feuchtigkeit eine gleichbleibende Amplitude.

Es ist von Vorteil, wenn die Erregerschwingungen aus dem Ausklingen eines periodisch einmalig angestoßenen Erreger-Schwingkreises entnommen werden. Dadurch können die Erregerschwingungen auf einfache Weise günstig mit wenigen Bauteilen erzeugt werden, liefern aber einen eindeutigen Signalverlauf, zum Beispiel in Sinusform.

Günstigerweise ist das Grundpotential ein elektrisches Erdpotential, da dadurch ein eindeutiges Bezugspotential geschaffen wird.

Vorzugsweise ist das Objekt mit der weiteren Kapazität eine Hand oder ein anderes Körperteil eines Menschen, da verfahrensgemäß deutlich zwischen einer Handannäherung bzw. der Annäherung eines Menschen und anderen geerdeten Kapazitäten wie z.B. einem feuchten Tuch oder einen Eis- oder Schneebelag unterschieden werden kann.

Bevorzugterweise nimmt eine weitere parallel zu der wenigstens einen Sensorelektrode angeordnete Elektrode EMV-Störungen auf, die auch die Sensorelektrode beeinflussen. Zwischen dem Signal aus der Sensorelektrode und dem Signal aus der weiteren Elektrode wird eine Differenz gebildet, um die EMV-Störungen zu eliminieren, indem die Differenz vom Ausgangssignal subtrahiert wird. Dadurch ist eine eindeutige Signalerkennung ohne EMV-Einflüsse möglich.

Günstigerweise wird das von der Erregerschaltung erzeugte Erregungssignal einseitig in eine Induktivität eingekoppelt, an deren anderen Ende ein Resonanzkondensator vorgesehen ist. Der Resonanzkondensator weist eine Sensorelektrode mit einer kleinen nach Erdpotential ausgebildeten Kapazität zur Erreichung einer Grundresonanz auf, wobei die Annäherung einer weiteren Kapazität zu einer von der Auswerteschaltung auswertbaren Verschiebung der Grundresonanz führt

Im Folgenden wird die Erfindung an Hand von in den beigefügten Figuren dargestellten Ausführungsbeispielen näher erläutert. Es zeigen:
- Fig. 1: eine Darstellung einer Schaltung des Grundprinzips des Sensors,
- Fig. 2: ein Diagramm mit Amplitudenverläufen der Spannung des Ausgangssignals des Schwingkreises der Schaltung gemäß Fig. 1 über der Zeit,
- Fig. 3: eine Schaltung gemäß Fig. 1 mit einem zwischen Frequenzgenerator und Induktivität geschalteten Schaltelement,
- Fig. 4: eine Erregungsschwingung sowie zugehörige Amplitudenverläufe der Spannung des Ausgangssignals des Schwingkreises gemäß Fig. 1 über der Zeit bei Handannäherung als auch bei Anwesenheit eines feuchten Tuchs,
- Fig. 5: eine Erregungsschwingung sowie zugehörige Amplitudenverläufe der Spannung des Ausgangssignals des Schwingkreises gemäß Fig. 1 über der Zeit sowohl bei Handannäherung als auch bei gleichzeitiger Anwesenheit eines feuchten Tuchs,
- Fig. 6: eine Zusammenfassung der Kurvenverläufe der Fig. 4 und 5,
- Fig. 7: eine Schaltung zur Erzeugung einer Erregungsschwingung,
- Fig. 8: eine EMV-stabile Sensoranordnung,
- Fig. 9: eine Schaltungsanordnung mit mehreren gemeinsam EMV-stabilen Sensoren,
- Fig. 10: eine Lagenanordnung einer zur Schaltungsvariante der Fig. 9 gehörigen Platine in dreidimensionaler Ansicht und als Schnittbild,
- Fig. 11: eine Schaltungsanordnung gemäß Fig. 9.

### Ausführliche Beschreibung bevorzugter Ausführungsbeispiele

Die Erfindung wird jetzt beispielhaft unter Bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen. Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

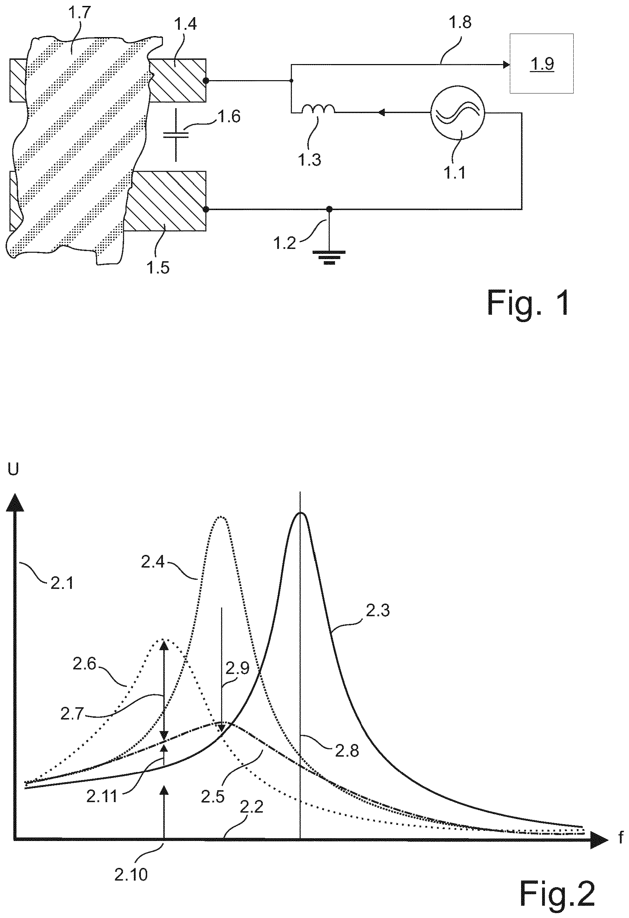

Die Figuren zeigen einen kapazitiven Annäherungssensor mit einer Sensoranordnung. Die Sensoranordnung weist gemäß Fig. 1 wenigstens eine Induktivität 1.3 und eine Kapazität 1.6 als Teil eines Schwingkreises auf. Die Kapazität 1. 6 ist dabei gegenüber einem Grundpotential 1.2 wie dem elektrischen Erdpotential oder einem anderen Bezugspotential gebildet.

Fig. 1 zeigt das Grundprinzip des Sensors. Ein Frequenzgenerator 1.1 speist eine Frequenz von z.B. 2 MHz in die Induktivität 1.3. Diese hat z.B. einen Wert von 470 µH. Die Elektrode 1.5 ist mit einem Grundpotential 1.2 verbunden. Die Elektrode 1.5 entspricht damit jeder auf einem Bezugspotential befindlichen also z.B. geerdeten, also auf elektrischem Erdpotential liegenden leitfähigen Umgebung. Dies können z.B. die metallischen Arme eines Produktionsroboters sein, aber auch ein Fahrzeugchassis oder die metallische Tür eines Fahrzeuges kann als elektrisches Erdpotential angesehen werden. Die Sensorelektrode 1.4 entspricht einem Resonanzkondensator. Der in Fig. 1 angedeutete Kondensator entspricht der wenigstens einen Kapazität 1.6 zwischen der Sensorelektrode und dem Grundpotential.

Das Objekt (Medium 1.7) stellt ein z.B. feuchtes (oder vollständig nasses) Tuch dar, stellvertretend für eine Verschmutzung z. B. durch nasse Blätter, Tau, Eisbildung oder Schnee (bei Verwendung im Außenbereich). Als Oberbegriff für dieses Objekt wird hier der Begriff eines Mediums 1.7 mit resistivem Anteil eingeführt.

Dieses Medium 1.7 kann direkt elektrisch mit dem Massepotential 1.2 verbunden sein. Die Sensorelektrode befindet sich vorzugsweise hinter einer isolierenden Fläche von z.B. 2mm Wandstärke. Dies entspricht z.B. einem Sensor in einem Fahrzeug, bei dem dieser sich nicht sichtbar hinter einer Kunststoffverkleidung befindet, während eine feuchte "Verschmutzung" direkt auf dem Fahrzeugchassis vorhanden sein oder aufliegen kann und auch die wenigstens eine Sensorelektrode 1.4 ganz oder zumindest teilweise überdeckt.

Die wenigstens eine Sensorelektrode 1.4 ist im Schwingkreis angeordnet. Eine Erregerschaltung 1.1 ist dazu bestimmt und geeignet, den Schwingkreis anzuregen. In Folge der Anregung ergibt sich ein am Schwingkreis abgreifbares Ausgangssignal 1.8. Eine Auswerteschaltung 1.9 ist dazu bestimmt und geeignet, das Ausgangssignal 1.8 zur Bestimmung der Annäherung eines Objekts auszuwerten.

Die Sensorelektrode 1.4 ist als Resonanzkondensator in den Schwingkreis eingebunden. Der Schwingkreis wird in einem Ausgangszustand von der Erregerschaltung 1.1 mit einer Frequenz unterhalb einer Resonanzfrequenz des Schwingkreises angeregt. Dies führt auf eine im Folgenden noch zu erläuternde Weise dazu, dass eine Amplitudenauswertung des Ausgangssignals möglich wird, um zwischen einem Medium 1.7 mit resistivem Anteil und der Annäherung einer weiteren Kapazität eines Objekts wie einer Hand zu unterscheiden. Das Medium 1.7 mit resistivem Anteil, das zwischen der Sensorelektrode 1.4 und dem Grundpotential 1.2 anordenbar ist, führt nämlich zu einer Verstimmung des Schwingkreises, die zu einem Ausgangssignal 1.8 führt. Dieses Ausgangssignal weist gegenüber dem Ausgangszustand jedoch eine gleichbleibende oder nahezu gleichbleibende Amplitude auf. Bei der Annäherung einer weiteren Kapazität eines Objekts an die Sensorelektrode 1.4 führt dies ebenfalls zu einer Verstimmung des Schwingkreises mit einem Ausgangssignal 1.8, das nun aber eine gegenüber dem Ausgangszustand geänderte Amplitude selbst bei Anwesenheit des Mediums 1.7 mit resistivem Anteil aufweist. Die Auswerteschaltung 1.9 ist dazu bestimmt und geeignet, die Annäherung der weiteren Kapazität an der Änderung der Amplitude des Ausgangssignals 1.8 zu erkennen.

Bei der ersten hier beschriebenen Betrachtung zur Funktionsweise wird der Einfluss des Mediums 1.7 noch nicht berücksichtigt.

Angenommen, ein Frequenzgenerator, der ein Beispiel für eine Erregerschaltung 1.1 ist, speist einen Frequenzsweep in die Induktivität 1.3 ein, bei der der Schwingkreis, gebildet aus der Induktivität 1.3 und der Kapazität 1.6 in Resonanz kommen kann. Zwischen der Induktivität 1.3 und der Kapazität 1.6 wird das Ausgangssignal 1.8 des Schwingkreises nun insbesondere hinsichtlich seiner Amplitude betrachtet.

Fig. 2 zeigt einen solchen Amplitudenverlauf. Auf der Y-Achse 2.1 ist die Signalspannung aufgetragen, der Frequenzverlauf auf der X-Achse 2.2 ist von links nach rechts ansteigend. Die Amplitudenkurve 2.3 entspricht dann dem Ausgangssignal 1.8 ohne Beeinflussung der Sensorelektrode, also ohne dass eine Verschmutzung, Nässe, Schneeschicht usw. vorliegt und auch keine Handannäherung stattgefunden hat. Der maximale Amplitudenwert der Kurve entspricht dann der Resonanzfrequenz 2.8.

Nähert sich eine Hand der Sensorfläche 1.4, so verändert diese das elektrische Feld, das heißt, die Kapazität 1.6 zwischen der Sensorelektrode 1.4 und dem Massepotential 1.2 vergrößert sich, was einer Verschiebung der Resonanzfrequenz hin zu tieferen Frequenzen entspricht, dargestellt in Kurve 2.4. Dabei ändert sich fast ausschließlich nur der Kapazitätswert zwischen Hand und Sensorelektrode, der resistive Anteil kann vernachlässigt werden.

Bei einer klassischen Amplitudenauswertung, bei der ja die Resonanzfrequenz 2.8 fest eingestellt ist, würde sich also eine Amplitudenabnahme ergeben, wie durch den Pfeil 2.9 angedeutet. Diese Amplitudenabnahme würde zur Erkennung der Handannäherung herangezogen.

Verbindet man jedoch bei diesem üblichen Verfahren mit fester Resonanzfrequenz 2.8 die Sensorelektrode 1.4 über das feuchte Tuch mit dem Erdpotential, ergibt sich eine starke Dämpfung des Ausgangssignals 1.8 bei gleichzeitiger Verschiebung der Resonanzfrequenz. Dies ist in Fig. 2, Amplitudenkurve 2.5 dargestellt. Die Dämpfung des Signals ist durch den über das feuchte Tuch entstehenden resistiven Anteil zu erklären.

Wie aus Fig. 2 zu erkennen, ist also eine Unterscheidung zwischen Handannäherung und Auflegen des feuchten Tuches zumindest in der Amplitudenabnahme des Ausgangssignals 1.8 nicht unterscheidbar, da an der neuen Resonanzstelle der Amplitudenwert der ursprünglichen Resonanzkurve bei Handannäherung und der Amplitudenwert, der durch Auflegen des feuchten Tuches entsteht, in etwa gleich sind. Zu erkennen ist dies im Bereich der Spitze des Pfeils 2.9.

Anders verhält es sich, wenn die Frequenz der Erregungsschaltung 1.1 bzw. eines Frequenzgenerators in einen unterhalb der Resonanzfrequenz 2.8 liegenden Bereich verschoben wird, also hin zu einer tieferen Frequenz, dargestellt in Pfeil 2.10. Wird jetzt das feuchte Tuch aufgelegt, erhöht sich das Ausgangssignal des Schwingkreises leicht, dargestellt durch Pfeil 2.11. Eine Handannäherung wird jetzt durch das feuchte Tuch hindurch deutlich erkannt, dargestellt in der Resonanzkurve 2.6. In der Praxis kann bei aufgelegtem feuchtem Tuch und darüber aufgelegter Hand oder Finger die Frequenz 2.10 so gewählt werden, dass sich der höchste Amplitudengewinn 2.7 ergibt.

Mit dieser Sensor-Ausführung lässt sich bereits eine Handannäherung durch nasse oder verschmutzte Oberflächen, Schnee oder Eisbelag hindurch gut detektieren. Jedoch führen ein Wasserschwall (Autowaschanlage) oder die oben genannten Einflussgrößen noch zu einerim Verhältnis zur Handannäherung - kleinen Änderung des Ausgangssignals 1.8.

Nach der Erfindung kann der Einfluss dieser Störgrößen vollständig eliminiert werden, sodass auch das Auflegen eines feuchten Tuches oder der Wasserschwall zu nahezu keiner Veränderung des Ausgangssignals 1.8 führen, eine Handannäherung dagegen deutlich erkannt wird.

Grundsätzlich ist die Erregerschaltung so ausgebildet, dass sie den Schwingkreis wenigstens zeitweise periodisch anregt. Dabei ist die Erregerschaltung so betreibbar, dass der Schwingkreis mit N Erregerschwingungen periodisch angeregt wird. Die Zahl N ist kleiner 10 ist und liegt vorzugsweise zwischen zwei und sechs. Es kann sich in diesem Bereich um eine beliebige Zahl handeln. Die Auswerteschaltung 1.9 ist dann dazu bestimmt und geeignet, am Schwingkreis die Amplitude des Ausgangssignals 1.8 während der und/oder kurz nach den N Erregerschwingungen auszuwerten. Vorzugsweise wird die Amplitude des Ausgangssignals nur während der ersten zwei bis sechs Erregerschwingungen ausgewertet, da dies den deutlichsten Signalunterschied und damit eine signifikante Objekterkennung ermöglicht. Als besonders bevorzugt hat sich für die Auswertung aber ein Zeitbereich herausgestellt, in dem sich kein Feuchtigkeitseinfluss in der Amplitudenbeeinflussung mehr zeigt, z.B. etwa ab der siebten Schwingung, d.h. es ergibt sich vorzugsweise mit und ohne Feuchtigkeit eine gleichbleibende Amplitude.

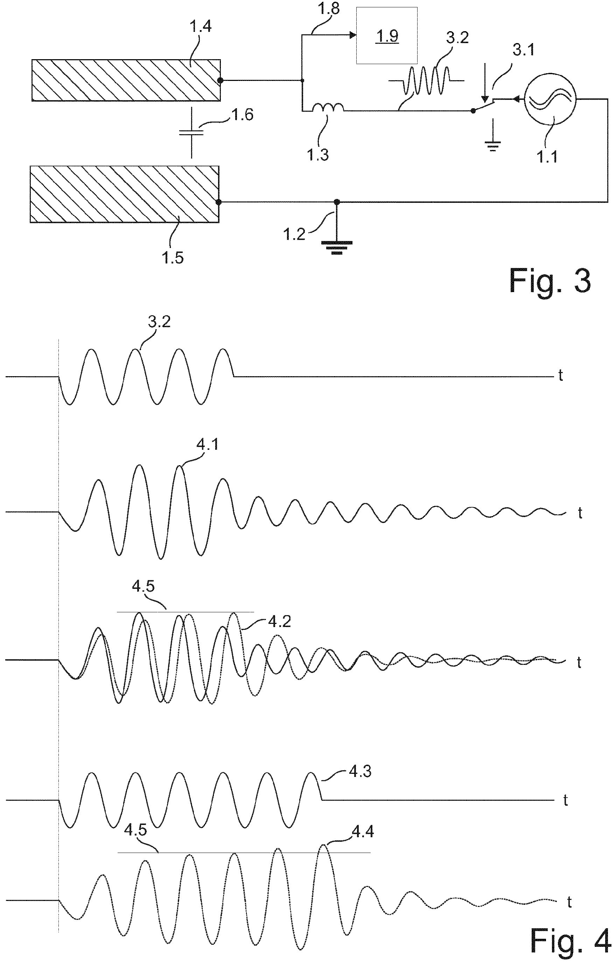

Um also insbesondere einen Wasserschwall noch deutlicher von einer Handannäherung zu unterscheiden, wird gemäß Fig. 3 ein Schaltelement 3.1 zwischen Erregerschaltung 1.1 und Induktivität 1.3 geschaltet. Dieses schaltet die Induktivität für z.B. zwei bis sechs Schwingungszüge an die Erregerschaltung 1.1, die restliche Zeit vorzugsweise an ein niederohmiges Ausgangspotential, z.B. das elektrische Erdpotential bzw. ein Grundpotential 1.2 oder an einen Widerstand. Der dadurch entstehende Schwingungszyklus an Erregerschwingungen 3.2 kann beliebig oft wiederholt werden, z.B. alle 10 ms. Aufgrund der Ein- und Ausschwingvorgänge des Schwingkreises aus Induktivität 1.3 und Kapazität 1.6 ergibt sich ein Ausgangssignal 1.8 des Schwingkreises gemäß Fig.4, Kurve 4.1.

Bei Resonanz des Schwingkreises auf die Erregerfrequenz der Erregerschaltung 1.1 ergibt sich bei den wenigen Erregerschwingungen 3.2 des Schwingungszyklus ein gleichmäßiges Ansteigen der am Schwingkreis resultierenden Spannung. Da aber die Frequenz des Erregerschaltung 1.1 entsprechend der Anfangs erwähnten Methode verschoben ist, entsteht die in Fig.4, 4.1 dargestellte Signalform.

Legt man nun das feuchte Tuch wie Anfangs beschrieben auf die Sensorelektrode 1.4, verändert sich die Phase des Ausgangssignals 1.8 wie in Fig. 4, 4.2 dargestellt. Die Phase verschiebt sich zwar, aber die Amplitude des Ausgangssignales 1.8 bleibt gleich groß, symbolisiert in der ersten Pegellinie 4.5.

Bei einer Amplitudenauswertung des Ausgangssignales ergibt sich daher mit oder ohne das feuchte Tuch, die feuchten Verschmutzungen, Wasser- Schnee- oder Eisbelag keine Veränderung gegenüber einer trockenen Sensorelektrode 1.4.

Bei einer größeren Anzahl als N Erregerschwingungen 3.2, dargestellt in Kurve 4.3, würde das Signal 4.2 in den weiteren Schwingungen 4.4 die erste Pegellinie 4.5 überschreiten. Dies bedeutet bei der Amplitudenauswertung, das feuchte Tuch würde zwar als "Störquelle" erkannt, jedoch könnten in diesem Fall bei einer Abtastung der Amplitudenwerte nur die ersten Schwingungen berücksichtigt werden, um das gleiche Ergebnis zu erzielen, wie es mit dem kurzen Schwingungszug an Erregerschwingungen 3.2 erreicht wurde. Im Übrigen ist die Anzahl der benötigten Erregerschwingungen abhängig von der Güte des Schwingkreises, gebildet aus der Induktivität 1.3 und der Kapazität 1.6. Erfahrungsgemäß liegt die Anzahl der Erregerschwingungen bei ca. zwei bis sechs Schwingungszügen. Die Erregerschwingungen 3.2 müssen auch nicht unbedingt eine Sinusform aufweisen, auch ein Rechtecksignal ist möglich.

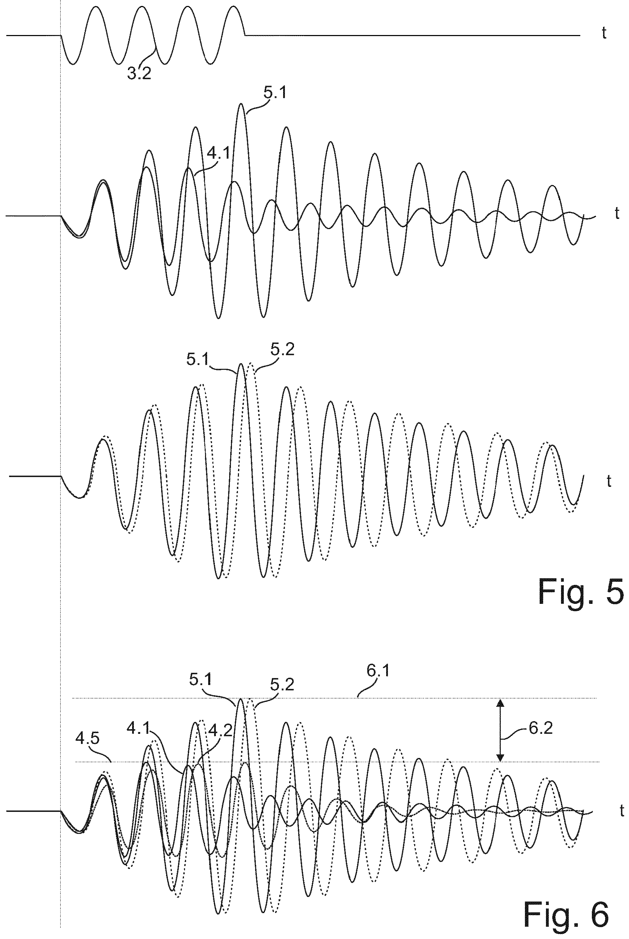

Somit ist die Grundlage geschaffen, das ein kapazitiver Annäherungssensor nicht auf Wasser oder eine feuchte Verschmutzung reagiert. Nähert sich jetzt eine Hand oder ein Finger (oder ein beliebiger anderer kapazitiv wirkender Gegenstand), verändert sich die Amplitude des Ausgangssignals 1.8 in der Art, dass die Amplitude signifikant ansteigt, dargestellt in Fig. 5, 5.1. Das feuchte Tuch über der Sensorelektrode 1.4 mit Verbindung zum Grundpotential 1.2 wie z.B. dem elektrischem Erdpotential verschiebt im Fall der Handannäherung nur die Phase des Ausgangssignals 1.8, ohne dass sich die Amplitude ändert, dargestellt in Kurve 5.2.

Fig. 6 zeigt eine Zusammenfassung der Kurvenverläufe. Die erste Pegellinie 4.5 wird ohne Handannäherung mit oder ohne feuchtem Tuch erreicht bzw. nicht überschritten, während bei Handannäherung mit oder ohne feuchtem Tuch die zweite Pegellinie 6.1 erreicht wird. Der Doppelpfeil 6.2 zeigt den möglichen Auswertebereich bei kontinuierlicher Handannäherung. Die Auswertung der Amplitude des Ausgangssignals kann linear oder über z.B. eine Schwellwertüberschreitung erfolgen.

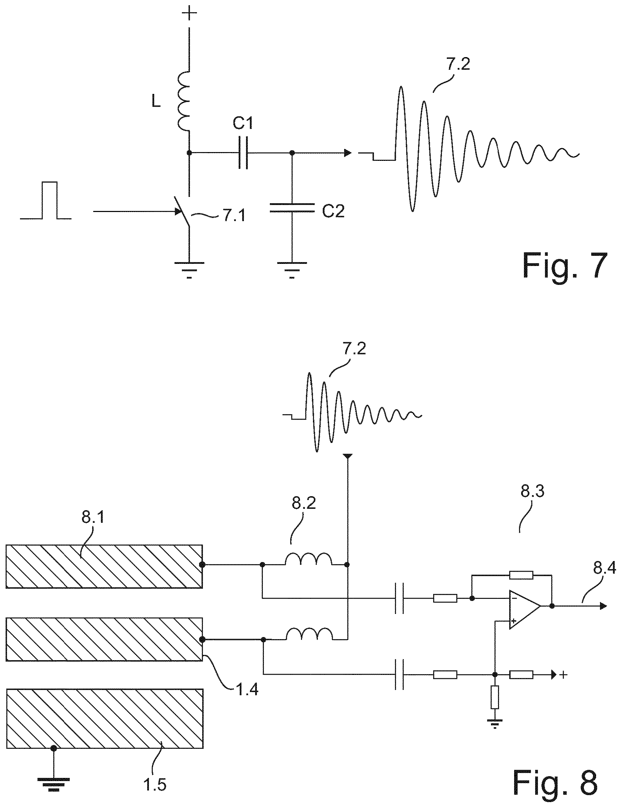

In den Fig. 1-6 wird von einer in der Amplitude kontinuierlichen Erregerschwingung ausgegangen, jedoch sind auch andere Erregerschwingungsformen möglich, dargestellt in Fig. 7.

Bevorzugterweise kann als Erregerschaltung 1.1 auch ein periodisch einmalig angestoßener Schwingkreis vorgesehen werden, wobei die Erregerschwingung aus dem Ausklingen des Schwingkreises entnommen sind. Über das Schaltelement 7.1 wird dazu in Fig. 7 die Induktivität L kurzzeitig bestromt, der beim Öffnen von 7.1 entstehende Rückschlagimpuls wird mittels der Resonanzkondensatoren C1 und C2 zu einem abklingenden Sinussignal 7.2 geformt. Dieses dient dann als Erregerschwingung 3.2. Zur Erreichung der gleichen Eigenschaften der Feuchteunabhängigkeit wie in den Figuren 4 bis 6 dargestellt, bedarf es lediglich einer entsprechenden geringen Anpassung der Erregerfrequenz, die ja durch den Wert der Induktivität L und der Kondensatoren C1 und C2 gebildet wird. Die Kondensatoren C1 und C2 bilden einen kapazitiven Spannungsteiler, wobei der Wert von C2 wesentlich größer als der Wert von C1 gewählt werden kann. Dadurch wirkt sich ein kapazitiver oder induktiver Einfluss auf das Signal an C2 weniger auf die Schwingkreiseigenschaften von L und C1 aus, als wenn das abklingende Sinussignal direkt an der Spule L abgenommen wird. Da bei entsprechender Bauteilgüte der Spule L ein abklingendes Sinussignal von z.B. 200Vpp in den ersten Schwingungen entsteht, kann der kapazitive Spannungsteiler diese Spannung durchaus auf ein Zehntel der 200Vpp herunterteilen, also z.B. auf 20 Vpp, wobei gleichzeitig auch vorteilhaft die Quellen-Impedanz verringert wird, was wiederum gut für die nachfolgende Schaltung (Fig.8) ist.

In manchen Fällen ist es vorteilhaft, den Annäherungssensor EMV-stabil auszubilden. Das heißt, externe Störfelder, auch auf der Resonanzfrequenz der Sensoranordnung, sollen keinen Einfluss auf das Sensorsystem ausüben.

Vorzugsweise ist dazu eine weitere Elektrode 8.1 parallel zu der wenigstens einen Sensorelektrode 1.4 oder auch zu mehreren Sensorelektroden angeordnet. Diese weitere Elektrode nimmt EMV-Störungen ebenso wahr wie die Sensorelektrode 1.4. Mittels eines Differenzbildners 8.3 kann eine Differenz zwischen dem Signal aus der Sensorelektrode 1.4 und dem Signal aus der weiteren Elektrode 8.1 gebildet werden, um die EMV-Störungen zu eliminieren.

Die weitere Elektrode 8.1 kann für sich oder zusammen mit einer weiteren Induktivität in der Nähe der Sensorelektrode 1.4, aber entfernt von der möglichen Handannäherung angeordnet werden. EMV-Störungen teilen sich beiden Elektroden mit, durch die Differenzbildung am Differenzbildner 8.3 löschen sie sich im Ausgangssignal 8.4 aus.

Selbstverständlich kann die weitere Elektrode 8.1 auch die Sensorelektrode 1.4 umgeben, was bei einer kreisförmigen Ausgestaltung der Sensorelektrode 1.4 und einer ringförmigen Ausführung der weiteren Elektrode 8.1 gegeben wäre.

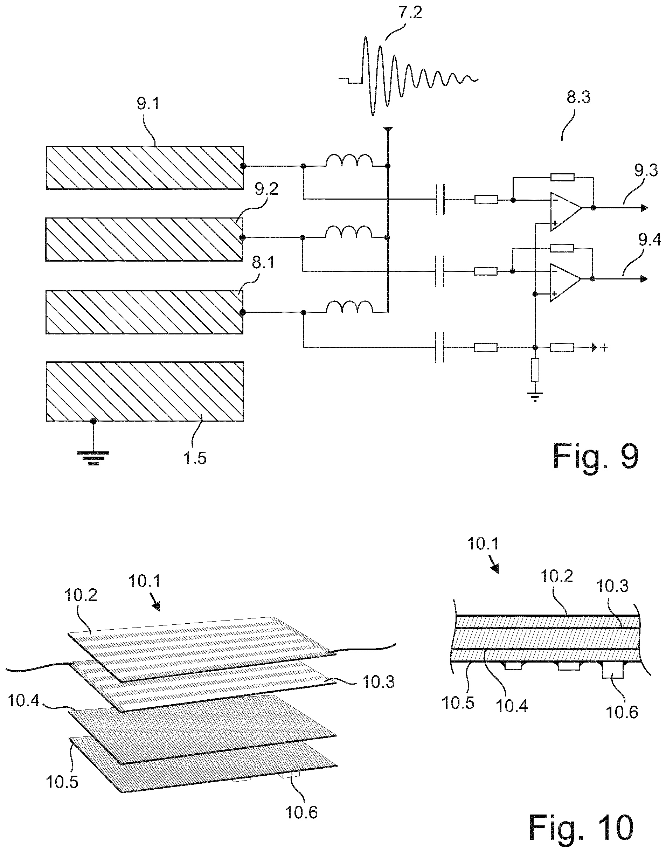

Wird eine Anordnung zweier Sensoren gefordert, die zudem noch gemeinsam EMV-stabil sein sollen, was z.B. im Türgriff eines Fahrzeugs gewünscht sein kann, wenn ein Sensor zum Öffnen und ein weiterer zum Verriegeln verwendet wird, erweist sich eine Schaltungsanordnung nach Fig. 9 als vorteilhaft. Die EMV-Elektrode 8.1 wirkt gemeinsam auf zwei Eingänge des Differenzbildners 8.3, während die Sensorelektroden 9.1 und 9.2 einen ersten und zweiten Annäherungssensor bilden und voneinander getrennte Ausgangssignale 9.3 und 9.4 liefern. Die Schaltungsanordnung ist dem Fachmann geläufig, so dass hier nicht näher darauf eingegangen wird.

Eine weitere bevorzugte Ausführungsform erlaubt die Positionierung der Sensorfläche auf einer Platine, wenn die auf Handannäherung empfindliche Fläche sich auf der einen Seite befindet, während auf der Rückseite der Platine, also hinter der Sensorfläche, Elektronickomponenten angeordnet sein sollen. In diesem Fall wäre die Grundkapazität der Sensorfläche gegenüber der Umgebung (Fläche mit den Bauteilen und Leiterbahnen) zu groß, um noch sinnvoll die kleinen Kapazitätsänderungen durch die Handannäherung zu detektieren.

Um dieses Problem zu umgehen, kann die Schaltungsanordnung auch anders gewählt werden. Fig. 10 zeigt die Lagenanordnung 10.1 der zur Schaltungsvariante gehörigen Platine in dreidimensionaler Ansicht und als Schnittbild (rechts). Die oberste Lage 10.2 entspricht der annäherungsempfindlichen Sensorelektrode. Diese wird vorzugsweise in Streifenform ausgeführt, kann aber auch vollflächig sein. Darunter befindet sich wiederum vorzugsweise in Streifenform ausgebildet eine Erregerelektrode 10.3 der Erregerschaltung 11.6. Die Streifenform kann gewählt werden, um die Eigenkapazität möglichst klein zu halten.

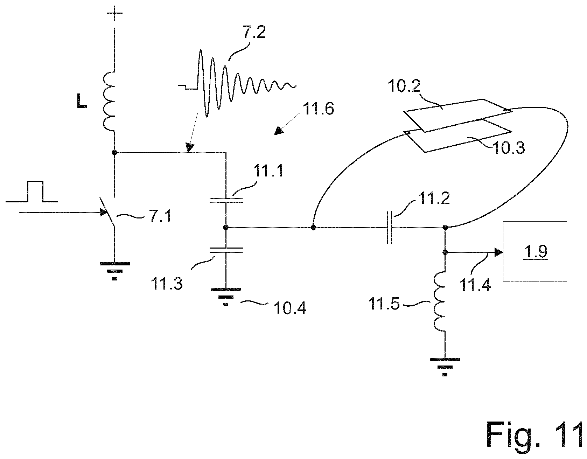

Die Erregerelektrode10.3 ist vorzugsweise über eine Kapazität 11.1 direkt an die Induktivität L angeschlossen. Beide Elektroden bilden eine Kapazität zueinander. Diese entspricht in der Schaltung in Fig. 11 der Kapazität 11.2.

Die Erregerelektrode bildet gleichzeitig eine Kapazität 11.3 mit einem Bezugspotential in Form einer vorzugsweise wechselspannungsseitig auf gnd liegenden Elektrodenfläche 10.4. Die untere Lage 10.5 nimmt die elektronischen Bauteile 10.6 und die dazugehörigen Leiterbahnen auf. Die Kapazität 11.3 entspricht dann der Kapazität C2 in Fig. 7 und bildet mit der Kapazität 11.1 einen kapazitiven Spannungsteiler.

Die Induktivität 11.5 bildet zusammen mit der Kapazität 11.2 und schwächer mit dem kapazitiven Spannungsteiler aus den Kapazitäten 11.1 und 11.3 einen Schwingkreis. Wird er gemäß der Darstellung in Fig. 2 betrieben (entsprechende Resonanzfrequenz), ergibt sich die beschriebene Unempfindlichkeit gegenüber Feuchtigkeit. In diesem Fall wird das Ausgangssignal 11.4 direkt an der Induktivität 11.5 abgenommen.

Mit diesem Annäherungssensor kann ein Verfahren zur Bestimmung der Annäherung eines Objekts an eine Sensoranordnung durchgeführt werden. Der Annäherungssensor weist in einem Schwingkreis wenigstens eine Induktivität 1.3 sowie wenigstens eine Kapazität 1.6 auf. Die Kapazität 1.6 bildet sich dabei zwischen einem Grundpotential 1.2 wie dem elektrischen Erdpotential und der Sensoranordnung aus. Im Schwingkreis ist eine Sensorelektrode 1.4 angeordnet. Der Schwingkreis wird von einer Erregerschaltung 1.1 erregt, wobei ein am Schwingkreis abgreifbares Ausgangssignal 1.8 von einer Auswerteschaltung 1.9 zur Bestimmung der Annäherung eines Objekts ausgewertet wird. Die Sensorelektrode 1.4 ist dabei als Resonanzkondensator in den Schwingkreis eingebunden.

Der Schwingkreis wird in einem Ausgangszustand von der Erregerschaltung mit einer Frequenz unterhalb einer Resonanzfrequenz des Schwingkreises angeregt. Ein Medium 1.7 mit resistivem Anteil, das zwischen der Sensorelektrode 1.4 und dem Grundpotential 1.2 angeordnet werden kann, führt zu einer Verstimmung des Schwingkreises mit einem Ausgangssignal 1.8, das gegenüber dem Ausgangszustand eine gleichbleibende oder nahezu gleichbleibende Amplitude, jedoch veränderte Phase aufweist. Die Annäherung einer weiteren Kapazität eines Objekts wie zum Beispiel einer Hand oder eines Fingers oder auch einer anderen Kapazität an die Sensorelektrode führt jedoch zu einer Verstimmung des Schwingkreises mit einem Ausgangssignal 1.8, das sich signifikant vom Ausgangszustand hinsichtlich seiner Amplitude unterscheidet. Dies gilt auch bei Anwesenheit der Mediums 1.7 mit resistivem Anteil wie eines feuchten, geerdeten Tuchs. Die Auswerteschaltung 1.9 kann die Annäherung der weiteren Kapazität an der Änderung der Amplitude des Ausgangssignals 1.8 erkennen.

Die Erregerschaltung 1.1, die wie oben beschrieben als Frequenzgenerator oder auf entsprechend andere Art und Weise ausgebildet sein kann, regt den Schwingkreis zumindest zeitweise periodisch an. Dazu wird der Schwingkreis mit N Erregerschwingungen 3.2 periodisch angeregt, das heißt nicht dauerhaft. Die Zahl N ist kleiner 10 und liegt vorzugsweise zwischen zwei und sechs. Die Auswerteschaltung 1.9 wertet dann am Schwingkreis die Amplitude des Ausgangssignals 1.8 während der und/oder kurz nach den N Erregerschwingungen aus. Als bevorzugt hat sich eine Auswertung der Amplitude des Ausgangssignals 1.8 nur während der ersten zwei bis sechs Erregerschwingungen herausgestellt. Als besonders bevorzugt hat sich für die Auswertung aber auch ein Zeitbereich herausgestellt, in dem sich kein Feuchtigkeitseinfluss in der Amplitudenbeeinflussung mehr zeigt, z.B. etwa ab der siebten Schwingung, d.h. es ergibt sich vorzugsweise mit und ohne Feuchtigkeit eine etwa gleichbleibende Amplitude.

Als Erregerschaltung kann auch eine Schaltung verwendet werden, die einen weiteren Schwingkreis aufweist. Die Erregerschwingungen 3.2 werden dann aus dem Ausklingen eines periodisch einmal angestoßenen Schwingkreises entnommen, wie dies bereits oben beschrieben wurde.

Als Grundpotential 1.2 wird vorzugsweise ein elektrisches Erdpotential verwendet. Das Objekt mit der weiteren Kapazität ist vorzugsweise eine Hand oder ein anderes Körperteil eines Menschen oder ein sonstiges Objekt im Wesentlichen ohne resistiven Anteil.

Bevorzugterweise wird eine weitere Elektrode 8.1 parallel zu der wenigstens einen Sensorelektrode 1.4 angeordnet. Diese weitere Elektrode 8.1 ist damit in der Lage EMV-Störungen aufzunehmen, die auch die Sensorelektrode beeinflussen. Wird dann eine Differenz zwischen dem Signal aus der Sensorelektrode 1.4 und dem Signal aus der weiteren Elektrode 8.1 gebildet, lassen sich EMV-Störungen eliminieren.

Durch die erfindungsgemäße Lösung werden so ein kapazitiver Annäherungssensor sowie ein Verfahren zur Bestimmung der Annäherung eines Objekts an die Sensoranordnung geschaffen, die nicht auf mäßig leitfähige Beläge wie z.B. einen geschlossenen Wasserfilm, feuchte Verschmutzungen, Schnee- oder Eisbelag reagieren, selbst wenn diese Beläge mit dem elektrischem Erdpotential verbunden sind und dabei die Sensorelektrode ganz oder teilweise überdecken. So kann durch diese geerdeten Beläge hindurch eine Handannäherung einwandfrei erkannt werden.

**Bezugszeichenliste**

| | | | |
|---|---|---|---|
| 1.1, 11.6 | Erregerschaltung | 4.2 | Ausgangssignal bei aufgelegtem feuchtem Tuch |
| 1.2 | Grundpotential (elektrisches Erdpotential) | | |
| | | 4.3 | Schwingungszyklus mit erhöhter Anzahl der Schwingungen |
| 1.3 | Induktivität | | |
| 1.4 | Sensorelektrode | 4.4 | Weitere Schwingungen |
| 1.5 | Elektrode mit Verbindung zum elektrischen Erdpotential | 4.5 | Erste Pegellinie |
| | | 5.1 | Angestiegene Amplitude des Aus-gangssignal 1.8 bei Handannäherung |
| 1.6 | Kapazität zwischen der Sensorelektrode und dem Erdpotential | | |
| 1.7 | Feuchtes Tuch | 5.2 | Phasenverschobenes Ausgangssig-nal 1.8 bei Handannäherung und feuchtem Tuch |
| 1.8 | Ausgangssignal des Schwingkreises | | |
| 1.9 | Auswerteeinrichtung | 6.1 | Zweite Pegellinie |
| 2.1 | Y-Achse (Spannung) | 6.2 | Auswertebereich bei Handannähe-rung |
| 2.2 | X-Achse (Frequenz) | | |
| 2.3 | Amplitudenkurve ohne Beeinflussung der Sensorelektrode | 7.1 | Schaltelement |
| | | 7.2 | abklingende Sinuskurve |
| 2.4 | Verschobene Resonanzkurve bei Handannäherung | 8.1 | weitere Elektrode |
| | | 8.2 | weitere Spule |
| 2.5 | Gedämpfte Amplitudenkurve durch feuchtes Tuch | 8.3 | Differenzbildner |
| | | 8.4 | EMV-bereinigtes Ausgangssignal |
| 2.6 | Resonanzkurve bei Handannäherung und aufgelegtem feuchten Tuch | 9.1, 9.2 | Sensorelektrode |
| | | 9.3, 9.4 | Ausgangssignal |
| | | 10.1 | Lagenanordnung der Platine |
| 2.7 | Amplitudengewinn | 10.2 | Sensorelektrode |
| 2.8 | Resonanzfrequenz | 10.3 | Erregerelektrode |
| 2.9 | Pfeil deutet Amplitudenabnahme an | 10.4 | wechselspannungsseitig auf gnd lie-gende Elektrodenfläche |
| 2.10 | Tiefere Frequenz unterhalb der Resonanzfrequenz | | |
| | | 10.5 | untere, bestückte Lage |
| 2.11 | Kleiner Anstieg des Ausgangssignals | 10.6 | elektronische Bauteile |
| | | 11.1-11.3 | Kapazität |
| 3.1 | Schaltelement | 11.4 | Ausgangssignal |
| 3.2 | Erregerschwingung | 11.5 | Induktivität |
| 4.1 | Ausgangssignal bei Ansteuerung des Schwingkreises mit Erregerschwingung | 11.6 | |
| | | L | Induktivität |
| | | C1, C2 | Resonanzkondensator |

## Patentansprüche

1. Kapazitiver Annäherungssensor mit einer Sensoranordnung mit
- einem wenigstens eine Induktivität (1.3; 11.5) und wenigstens eine Kapazität (1.6; 11.2) aufweisenden Schwingkreis, wobei die Kapazität (1.6; 11.2) gegenüber einem Grundpotential (1.2) gebildet ist,
- wenigstens einer als Resonanzkondensator im Schwingkreis eingebunden Sensorelektrode (1.4; 10.2),
- einer Erregerschaltung (1.1; 11.6), die zur Erregung des Schwingkreises bestimmt und geeignet ist, wobei der Schwingkreis in einem Ausgangszustand von der Erregerschaltung (1.1; 11.6) mit einer Frequenz unterhalb einer Resonanzfrequenz des Schwingkreises angeregt ist,
- einem am Schwingkreis abgreifbaren Ausgangssignal (1.8; 11.4),
- wobei ein Medium (1.7) mit resistivem Anteil, das durch eine feuchte Verschmutzung oder ein feuchtes Tuch gebildet ist, das mit dem Grundpotential (1.2) verbindbar ist und das zwischen der Sensorelektrode (1.4; 10.2) und dem Grundpotential (1.2) anordenbar ist, zu einer Verstimmung des Schwingkreises führt, während eine Annäherbarkeit einer weiteren Kapazität eines Objekts an die Sensorelektrode (1.4; 10.2) zu einer Verstimmung des Schwingkreises mit einem Ausgangssignal (1.8; 11.4) mit einer gegenüber dem Ausgangszustand geänderten Amplitude selbst bei Anwesenheit des Mediums (1.7) mit resistivem Anteil führt,
- wobei eine Auswerteschaltung (1.9) dazu bestimmt und geeignet ist, das Ausgangssignal (1.8; 11.4) zur Bestimmung der Annäherung der weiteren Kapazität auszuwerten und die Annäherung der weiteren Kapazität an der Änderung der Amplitude des Ausgangssignals (1.8; 11.4) zu erkennen,
**dadurch gekennzeichnet, dass**
die Verstimmung des Schwingkreises durch das Medium (1.7) mit resistivem Anteil zu einem Ausgangssignal (1.8; 11.4) mit einer gegenüber dem Ausgangszustand gleichbleibenden Amplitude selbst bei Anwesenheit des Mediums (1.7) mit resistivem Anteil führt, und
die Erregerschaltung (1.1; 11.6) so betreibbar ist, dass der Schwingkreis mit N Erregerschwingungen periodisch angeregt wird, wobei N eine Zahl kleiner 10 ist, wobei die Auswerteschaltung (1.9) dazu bestimmt und geeignet ist, am Schwingkreis die Amplitude des Ausgangssignals (1.8; 11.4) während der und/oder kurz nach den N Erregerschwingungen auszuwerten.

2. Kapazitiver Annäherungssensor nach Anspruch 1, **dadurch gekennzeichnet, dass** die Erregerschaltung (1.1; 11.6) dazu bestimmt und geeignet ist, den Schwingkreis wenigstens zeitweise periodisch anzuregen.

3. Kapazitiver Annäherungssensor nach Anspruch 1 oder 2, **dadurch gekennzeichnet, dass** N eine Zahl zwischen 2 und 6 ist.

4. Kapazitiver Annäherungssensor nach Anspruch 2 oder 3, **dadurch gekennzeichnet, dass** die Erregerschaltung (1.1; 11.6) einen periodisch einmalig angestoßenen Schwingkreis umfasst, wobei die Erregerschwingungen aus dem Ausklingen eines Schwingkreises entnommen sind.

5. Kapazitiver Annäherungssensor nach einem der vorhergehenden Ansprüche, **dadurch gekennzeichnet, dass** das Objekt mit der weiteren Kapazität eine Hand oder ein anderes Körperteil eines Menschen ist.

6. Kapazitiver Annäherungssensor nach einem der vorhergehenden Ansprüche, **dadurch gekennzeichnet, dass** wenigstens eine weitere Elektrode (8.1) parallel zu der wenigstens einen Sensorelektrode (1.4; 10.2) angeordnet ist und dazu bestimmt und geeignet ist, EMV-Störungen aufzunehmen, die auch die Sensorelektrode beeinflussen, und dass ein Differenzbildner (8.3) zur Bildung ein Differenz zwischen dem Signal aus der Sensorelektrode und dem Signal aus der weiteren Elektrode (8.1) vorgesehen ist, um über eine Differenzbildung die EMV-Störungen zu eliminieren.

7. Verfahren zur Bestimmung der Annäherung eines Objekts an eine Sensoranordnung eines kapazitiven Annäherungssensors mit
- einem wenigstens eine Induktivität (1.3; 11.5) und wenigstens eine Kapazität (1.6; 11.2) aufweisenden Schwingkreis, wobei die Kapazität (1.6; 11.2) gegenüber einem Grundpotential (1.2) gebildet ist,
- wenigstens einer im Schwingkreis als Resonanzkondensator eingebundenen Sensorelektrode (1.4; 10.2),
- wobei der Schwingkreis von einer Erregerschaltung (1.1; 11.6) erregt wird,
- wobei ein am Schwingkreis abgreifbares Ausgangssignal (1.8; 11.4) von einer Auswerteschaltung (1.9) zur Bestimmung der Annäherung eines Objekts ausgewertet wird,
- wobei der Schwingkreis in einem Ausgangszustand von der Erregerschaltung (1.1; 11.6) mit einer Frequenz unterhalb einer Resonanzfrequenz des Schwingkreises angeregt wird,
- wobei ein Medium (1.7) mit resistivem Anteil, das durch eine feuchte Verschmutzung oder ein feuchtes Tuch gebildet ist, das mit dem Grundpotential (1.2) verbindbar ist und das zwischen der Sensorelektrode (1.4; 10.2) und dem Grundpotential (1.2) anordenbar ist, zu einer Verstimmung des Schwingkreises führt, während eine Annäherung einer weiteren Kapazität eines Objekts an die Sensorelektrode (1.4; 10.2) zu einer Verstimmung des Schwingkreises mit einem Ausgangssignal (1.8; 11.4) mit einer gegenüber dem Ausgangszustand geänderten Amplitude selbst bei Anwesenheit des Mediums (1.7) mit resistivem Anteil führt,
- wobei die Auswerteschaltung (1.9) die Annäherung der weiteren Kapazität an der Änderung der Amplitude des Ausgangssignals (1.8; 11.4) erkennt,
**dadurch gekennzeichnet, dass**
die Verstimmung des Schwingkreises durch das Medium (1.7) mit resistivem Anteil zu einem Ausgangssignal (1.8; 11.4) mit einer gegenüber dem Ausgangszustand gleichbleibenden Amplitude selbst bei Anwesenheit des Mediums (1.7) mit resistivem Anteil führt, und
der Schwingkreis mit N Erregerschwingungen periodisch angeregt wird, wobei N eine Zahl kleiner 10 ist, wobei die Auswerteschaltung (1.9) am Schwingkreis die Amplitude des Ausgangssignals (1.8; 11.4) während der und/oder kurz nach den N Erregerschwingungen auswertet.

8. Verfahren nach Anspruch 7, **dadurch gekennzeichnet, dass** die Erregerschaltung (1.1; 11.6) den Schwingkreis wenigstens zeitweise periodisch anregt.

9. Verfahren nach Anspruch 7 oder 8, **dadurch gekennzeichnet, dass** N eine Zahl zwischen 2 und 6 ist.

10. Verfahren nach Anspruch 9, **dadurch gekennzeichnet, dass** die Erregerschwingungen aus dem Ausklingen eines periodisch einmalig angestoßenen Schwingkreises entnommen werden.

11. Verfahren nach einem der Ansprüche 7 bis 10, **dadurch gekennzeichnet, dass** das Objekt mit der weiteren Kapazität eine Hand oder ein anderes Körperteil eines Menschen ist.

12. Verfahren nach einem der Ansprüche 7 bis 11, **dadurch gekennzeichnet, dass** wenigstens eine weitere parallel zu der wenigstens einen Sensorelektrode (1.4; 10.2) angeordnete Elektrode (8.1) EMV-Störungen aufnimmt, die auch die Sensorelektrode beeinflussen, und dass eine Differenz zwischen dem Signal aus der Sensorelektrode (1.4; 10.2) und dem Signal aus der weiteren Elektrode (8.1) gebildet wird, um die EMV-Störungen zu eliminieren.

## Claims

1. A capacitive proximity sensor with a sensor arrangement with
- a resonant circuit which has at least one inductance (1.3; 11.5) and at least one capacitance (1.6; 11.2), the capacitance (1.6; 11.2) being formed relative to a ground potential (1.2).
- at least one sensor electrode (1.4; 10.2) incorporated as a resonance capacitor in the resonant circuit,
- an exciter circuit (1.1; 11.6), which is intended and suitable for exciting the resonant circuit, the resonant circuit being excited in a starting state by the exciter circuit (1.1; 11.6) with a frequency below a resonance frequency of the resonant circuit,
- an output signal (1.8; 11.4) that can be tapped at the resonant circuit,
- a medium (1.7) with a resistive component formed by a moist contamination or a moist fabric connectable to the ground potential (1.2) and arrangeable between the sensor electrode (1.4; 10.2) and the ground potential (1.2) leading to a detuning of the resonant circuit, whereas the possibility of a further capacitance of an object approaching the sensor electrode (1.4; 10.2) leads to a detuning of the resonant circuit with an output signal (1.8; 11.4) having an amplitude that is altered in relation to the starting state, even in the presence of the medium (1.7) having a resistive component,
- an evaluation circuit (1.9) being intended and suitable for evaluating the output signal (1.8; 11.4) to determine the proximity of the further capacitance and to identify the proximity of the further capacitance on the basis of the change to the amplitude of the output signal (1.8; 11.4),
**characterised in that**
the detuning of the resonant circuit by the medium (1.7) having a resistive component leads to an output signal (1.8; 11.4) with an amplitude that remains the same in relation to the starting state, even in the presence of the medium (1.7) having a resistive component, and
the exciter circuit (1.1; 11.6) is operable such that the resonant circuit is excited periodically with N exciter oscillations, N being a number smaller than 10, the evaluation circuit (1.9) being intended and suitable for evaluating, at the resonant circuit, the amplitude of the output signal (1.8; 11.4) during the and/or shortly after the N exciter oscillations.

2. A capacitive proximity sensor in accordance with claim 1, **characterised in that** the exciter circuit (1.1; 11.6) is intended and suitable for exciting the resonant circuit periodically at least temporarily.

3. A capacitive proximity sensor in accordance with claim 1 or 2, **characterised in that** N is a number between 2 and 6.

4. A capacitive proximity sensor in accordance with claim 2 or 3, **characterised in that** the exciter circuit (1.1; 11.6) comprises a resonant circuit triggered once periodically, the exciter oscillations being taken from the decay of a resonant circuit.

5. A capacitive proximity sensor in accordance with the preceding claims, **characterised in that** the object with the further capacitance is a hand or another body part of a person.

6. A capacitive proximity sensor in accordance with the preceding claims, **characterised in that** at least one further electrode (8.1) is arranged parallel to the at least one sensor electrode (1.4; 10.2) and is intended and suitable for receiving EMC interference, which also influences the sensor electrode, and **in that** a difference former (8.3) is provided for forming a difference between the signal from the sensor electrode and the signal from the further electrode (8.1), in order to eliminate the EMC interference by means of the forming of a difference.

7. A method for determining the approach of an object towards a sensor arrangement of a capacitive proximity sensor with
- a resonant circuit which has at least one inductance (1.3; 11.5) and at least one capacitance (1.6; 11.2), the capacitance (1.6; 11.2) being formed relative to a ground potential (1.2).
- at least one sensor electrode (1.4; 10.2) incorporated as a resonance capacitor in the resonant circuit,
- the resonant circuit being excited by an exciter circuit (1.1; 11.6),
- an output signal (1.8; 11.4) that can be tapped at the resonant circuit being evaluated by an evaluation circuit (1.9) to determine the proximity of an object,
- the resonant circuit being excited in a starting state by the exciter circuit (1.1; 11.6) with a frequency below a resonance frequency of the resonant circuit,
- a medium (1.7) with a resistive component formed by a moist contamination or a moist fabric connectable to the ground potential (1.2) and arrangeable between the sensor electrode (1.4; 10.2) and the ground potential (1.2) leading to a detuning of the resonant circuit, whereas a further capacitance of an object approaching the sensor electrode (1.4; 10.2) leads to a detuning of the resonant circuit with an output signal (1.8; 11.4) having an amplitude that is altered in relation to the starting state, even in the presence of the medium (1.7) having a resistive component,
- the evaluation circuit (1.9) identifying the proximity of the further capacitance on the basis of the change to the amplitude of the output signal (1.8; 11.4),
**characterised in that**
the detuning of the resonant circuit by the medium (1.7) having a resistive component leads to an output signal (1.8; 11.4) with an amplitude that remains the same in relation to the starting state, even in the presence of the medium (1.7) having a resistive component, and the resonant circuit is excited periodically with N exciter oscillations, N being a number smaller than 10, the evaluation circuit (1.9) evaluating, at the resonant circuit, the amplitude of the output signal (1.8; 11.4) during the and/or shortly after the N exciter oscillations.

8. A method in accordance with claim 7, **characterised in that** the exciter circuit (1.1; 11.6) periodically excites the resonant circuit at least temporarily.

9. A method in accordance with claim 7 or 8, **characterised in that** N is a number between 2 and 6.

10. A method in accordance with claim 9, **characterised in that** the exciter oscillations are taken from the decay of a resonant circuit triggered once periodically.

11. A method in accordance with claims 7 to 10, **characterised in that** the object with the further capacitance is a hand or another body part of a person.

12. A method in accordance with claims 7 to 11, **characterised in that** at least one further electrode (8.1) arranged parallel to the at least one sensor electrode (1.4; 10.2) receives EMC interference, which also influences the sensor electrode, and **in that** a difference is formed between the signal from the sensor electrode (1.4; 10.2) and the signal from the further electrode (8.1), in order to eliminate the EMC interference.

## Revendications

1. Capteur de proximité capacitif à dispositif de détection, comportant
- un circuit oscillant comprenant au moins une inductance (1.3 ; 11.5) et au moins un condensateur (1.6 ; 11.2), le condensateur (1.6 ; 11.2) étant formé par rapport à un potentiel de base (1.2),
- au moins une électrode de détection (1.4 ; 10.2) incorporée dans le circuit oscillant en tant que condensateur de résonance,
- un circuit d'excitation (1.1 ; 11.6) qui est prévu pour et apte à l'excitation du circuit oscillant, le circuit oscillant étant excité à l'état initial par le circuit d'excitation (1.1 ; 11.6) avec une fréquence inférieure à une fréquence de résonance du circuit oscillant ;
- un signal de sortie (1.8 ; 11.4) pouvant être capté au niveau du circuit oscillant ;
- un milieu (1.7) avec une partie résistive, qui est formé par une pollution humide ou un tissu humide qui peut être connecté au potentiel de base (1.2) et qui peut être disposé entre l'électrode de détection (1.4 ; 10.2) et le potentiel de base (1.2), tandis qu'une approche d'une autre capacité d'un objet de l'électrode de détection (1.4 ; 10.2) conduit à un désaccord du circuit oscillant avec un signal de sortie (1.8 ; 11.4) avec une amplitude modifiée par rapport à l'état initial même en case de présence du milieu (1.7) avec une partie résistive,
- un circuit d'exploitation (1.9) étant prévu et apte à exploiter le signal de sortie (1.8 ; 11.4) pour la détermination de l'approche de l'autre capacité et à reconnaître l'approche de l'autre capacité au changement de l'amplitude du signal de sortie (1.8 ; 11.4),
**caractérisé en ce que**
le désaccord du circuit oscillant conduit, par l'intermédiaire du milieu (1.7) avec une partie résistive, à un signal de sortie (1.8 ; 11.4) avec une amplitude restant constante par rapport à l'état initial même en cas de présence du milieu (1.7) avec une partie résistive et
le circuit d'excitation (1.1 ; 11.6) peut être actionnable de telle sorte que le circuit oscillant soit excitable périodiquement avec N oscillations d'excitation, N étant un nombre inférieur à 10, le circuit d'exploitation (1.9) étant prévu et apte à exploiter au niveau du circuit oscillant, l'amplitude du signal de sortie (1.8 ; 11.4) pendant les et/ou juste après les N oscillations d'excitation.

2. Capteur de proximité capacitif selon la revendication 1, **caractérisé en ce que** le circuit d'excitation (1.1 ; 11.6) est prévu et apte à exciter périodiquement le circuit oscillant au moins par intermittence.

3. Capteur de proximité capacitif selon la revendication 1 ou 2, **caractérisé en ce que** N est un nombre compris entre 2 et 6.

4. Capteur de proximité capacitif selon la revendication 2 ou 3, **caractérisé en ce que** le circuit d'excitation (1.1 ; 11.6) comprend un circuit oscillant activé une seule fois périodiquement, les oscillations d'excitation pouvant être prélevées de la fin d'un circuit oscillant.

5. Capteur de proximité capacitif selon l'une des revendications précédentes, **caractérisé en ce que** l'objet avec l'autre capacité est une main ou une autre partie d'un corps humain.

6. Capteur de proximité capacitif selon l'une des revendications précédentes, **caractérisé en ce qu'**au moins une autre électrode (8.1) est disposée en parallèle avec la ou les électrode(s) de détection (1.4 ; 10.2) et est conçue et apte à enregistrer des perturbations CEM qui influencent également l'électrode de détection et **en ce qu'**est prévu un générateur de différence (8.3) pour créer une différence entre le signal provenant de l'électrode de détection et le signal provenant de l'autre l'électrode (8.1), afin d'éliminer les perturbations CEM au moyen d'une création de différence.

7. Procédé de détermination de l'approche d'un objet d'un dispositif de détection d'un capteur de proximité capacitif, comportant
- au moins une inductance (1.3 ; 11.5) et au moins un circuit oscillant présentant un condensateur (1.6 ; 11.2), le condensateur (1.6 ; 11.2) étant formé par rapport à un potentiel de base (1.2) ;
- au moins une électrode de détection incorporée dans le circuit oscillant en tant que capacité de résonance (1.4 ; 10.2),
- le circuit oscillant étant excité par un circuit d'excitation (1.1 ; 11.6),
- un signal de sortie (1.8 ; 11.4) pouvant être capté au niveau du circuit oscillant par un circuit d'exploitation (1.9) étant exploité pour la détermination de l'approche d'un objet,
- le circuit oscillant étant excité dans un état initial par le circuit d'excitation (1.1 ; 11.6) avec une fréquence inférieure à la fréquence de résonance du circuit oscillant,
- un milieu (1.7) avec une partie résistive, qui est formé par une pollution humide ou un tissu humide, qui peut être connecté au potentiel de base (1.2) et qui peut être disposé entre l'électrode de détection (1.4 ; 10.2) et le potentiel de base (1.2), conduit à un désaccord du circuit oscillant, tandis qu'une approche d'une autre capacité d'un objet de l'électrode de détection (1.4; 10.2) conduit à un désaccord du circuit oscillant avec le signal de sortie (1.8 ; 11.4) avec une amplitude modifiée par rapport à l'état initial même en cas de présence du milieu (1.7) avec une partie résistive,
- le circuit d'exploitation (1.9) reconnaissant l'approche de l'autre capacité au changement de l'amplitude du signal de sortie (1.8 ; 11.4),
**caractérisé en ce que**
le désaccord du circuit oscillant conduit par l'intermédiaire du milieu (1.7) avec une partie résistive à un signal de sortie (1.8 ; 11.4) avec une amplitude restant constante par rapport à l'état initial même en cas de présence du milieu (1.7) avec une partie résistive, et le circuit oscillant et
le circuit oscillant est excité périodiquement avec N oscillations d'excitation, N étant un nombre inférieur à 10, le circuit d'exploitation (1.9) exploitant l'amplitude du signal de sortie (1.8 ; 11.4) au niveau du circuit oscillant pendant et/ou juste après les N oscillations d'excitation.

8. Procédé selon la revendication 7, **caractérisé en ce que** le circuit d'excitation (1.1 ; 11.6) excite périodiquement le circuit oscillant au moins par intermittence.

9. Procédé selon la revendication 7 ou 8, **caractérisé en ce que** N est un nombre compris entre 2 et 6.

10. Procédé selon la revendication 9, **caractérisé en ce que** les oscillations d'excitation sont prélevées de la fin d'un circuit oscillant activé périodiquement une seule fois.

11. Procédé selon l'une des revendications 7 à 10, **caractérisé en ce que** l'objet avec une autre capacité est une main ou une autre partie d'un corps humain.

12. Procédé selon l'une des revendications 7 à 11, **caractérisé en ce qu'**au moins une autre électrode (8.1) disposée en parallèle à la ou les électrode(s) de détection (1.4 ; 10.2) enregistre les perturbations CEM, qui influencent aussi l'électrode de détection, et **en ce qu'**une différence est créée entre le signal provenant de l'électrode de détection (1.4 ; 10.2) et le signal provenant de l'autre électrode (8.1) est créée, afin d'éliminer les perturbations CEM.
